# EUROPÄISCHE PATENTSCHRIFT

(11) **EP 3 314 754 B1**
(45) Veröffentlichungstag und Bekanntmachung des Hinweises auf die Patenterteilung: **07.04.2021**
(21) Anmeldenummer: 16742157.7
(22) Anmeldetag: 11.05.2016
(51) Int. Cl.: H03B 5/04, H03B 5/32, H03H 9/02, H03H 9/205

(54) **OSZILLATOR MIT VERRINGERTER BESCHLEUNIGUNGSEMPFINDLICHKEIT**
OSCILLATOR WITH REDUCED ACCELERATION SENSITIVITY
OSCILLATEUR AYANT UNE SENSIBILITÉ À L'ACCÉLÉRATION RÉDUITE

(30) Priorität: 11.05.2015 DE 102015107384; 12.05.2015 DE 102015107495; 29.09.2015 DE 102015116529; 02.10.2015 DE 102015116815
(43) Veröffentlichungstag der Anmeldung: 02.05.2018
(73) Patentinhaber: KVG Quartz Crystal Technology GmbH, 74924 Neckarbischofsheim (DE)
(72) Erfinder: SAUR-BROSCH, Roland, 69126 Heidelberg (DE)
(86) Internationale Anmeldenummer: PCT/DE2016/200222
(87) Internationale Veröffentlichungsnummer: WO 2016/180417

(56) Entgegenhaltungen:
- US-A- 4 410 822
- US-A- 4 575 690
- US-A1- 2009 201 096
- US-A1- 2015 263 672

## Beschreibung

Die Erfindung betrifft Oszillatoren mit verringerter Beschleunigungsempfindlichkeit, sowie Methoden die Beschleunigungsempfindlichkeit von Oszillatoren zu verringern. Elektronische Oszillatoren werden üblicherweise eingesetzt um Frequenzen zu erzeugen.

Um die Frequenz zu kontrollieren werden üblicherweise Resonatoren eingesetzt, die mit dem elektronischen Oszillator gekoppelt werden.

Beispielsweise werden Quarzkristalle als Resonatoren eingesetzt. Es kommen aber auch andere Kristalle zur Anwendung, wie z.B. Lithiumtantalat, Lithiumniobat uvm. Wird ein Resonator einer Beschleunigungskraft ausgesetzt, so ändert sich seine charakteristische Frequenz und infolgedessen auch die Frequenz des durch den Resonator kontrollierten Oszillators.

In bestimten Anwendungsgebieten ist eine Abhängigkeit der Frequenz von der Beschleunigungskraft (Beschleunigungsempfindlichkeit) unerwünscht, weil sie zu unerwünschten Frequenzänderungen führen kann. Beispielsweise ist dies der Fall bei der Anwendung in Fahrzeugen, Flugzeugen und sonstigen nichtstationären Anwendung. Andere Beispiele für solche Fälle sind Umgebungen mit rotierenden oder vibrierenden Massen.

In der Patentanmeldung US12/613336, eingereicht am 5. November 2009, und der aus ihr hervorgegangenen US2015/263672 wird beschrieben, wie die Beschleunigungsempfindlichkeit verringert werden kann, wenn mehrere Resonatoren verwendet werden, die um 180° gegeneinander gedreht angeordnet sind und bei denen Beträge und Richtungen der Vektoren im Wesentlichen gleich sind. Auf die entsprechende Beschreibung in der US12/613336 wird in vollem Umfang bezug genommen
Die Erfindung wird durch den unabhängigen Anspruch 1 definiert.

Im Rahmen der Erfindung wurde nun aber überraschend herausgefunden, dass die Beschleunigungsempfindlichkeit besonders stark vermindert werden kann, wenn zwei Resonatoren, die mechanisch antiparallel angeordnet sind, z.B. indem sie um mindestens eine Achse um 180° gegeneinander verdreht sind, so hergestellt oder aus einer größeren Menge von Resonatoren ausgesucht sind/werden, dass die Beträge der Vektoren der Beschleunigungsempfindlichkeit im Wesentlichen gleich sind, die Richtung des Vektors eines der beiden Resonatoren gegenüber der Richtung des anderen Resonators an der Ebene, die senkrecht zu besagter Achse ist, gespiegelt ist.

Hierbei kann überraschenderweise sogar eine bessere antiparallele Ausrichtung der Vektoren erreicht werden, als bei Verwendung von Resonatoren, deren Vektoren im wesentlichen in die gleiche Richtung zeigen, weshalb die Erfindung dies vorschlägt.

Insbesondere dann, wenn die Vektoren nicht im Wesentlichen senkrecht zu der Achse sind, um welche mindestens einer der Resonatoren gegenüber midestens einem anderen der Resonatoren verdreht ist, ergibt solch eine Ausführungsform eine besonders gute antiparallele Ausrichtung der Vektoren. Vorzugsweise kann der verwendbare Bereich der Winkel der Vektoren durch Verwendung solcher Ausführungsformen vergrößert werden, wodurch vorzugsweise die Ausbeute bei der Herstellung gesteigert werden kann.

In einer weiteren bevorzugten Ausführungsform wird die Genauigkeit der antiparallelen Ausrichtung der Vektoren verbessert.

Bei der Verwendung von Resonatoren, bei denen die Größe der Vektoren im Wesentlichen gleich ist, die Richtung der Vektoren jedoch nicht gleich ist oder sein muss, sondern die Richtung des Vektors eines der beiden Resonatoren gegenüber der Richtung des Vektors des anderen Resonators an der Ebene, die senkrecht zur dieser Achse ist, gespiegelt ist, ist der Winkelbereich, den die Richtungen der Vektoren haben dürfen, um bei antiparalleler Ausrichtung der Resonatoren bzw. deren Montagefläche, eine möglichst antiparallele Ausrichtung der Vektoren oder eine antiparallele Ausrichtung mit einer bestimmten Maximalabweichung der Vektoren zu erreichen, vergrößert, weshalb eine beforzugte Ausführungsform der Erfindung dies vorschlägt. Im Folgenden wird als Resonator auch ein Resonator bezeichnet, welcher in einem Gehäuse montiert ist. Dies kann beispielsweise ein Gehäuse aus Keramik sein, aber auch eines aus Metall.

Die Richtungen von Vektoren werden bei in solchen Gehäusen montierten Resonatoren auf das Resonatorgehäuse angegeben.

Vorzugsweise liegt die Achse, um welche mindestens einer der Resonatoren gegenüber mindestens einem anderen mechanisch um 180° verdreht ist, in einer Ebene, welche parallel zur Montagefläche eines der Resonatoren ist.

Mehr bevorzugt ist diese Achse parallel zu einer Kante eines der Resonatoren, bzw. zu einer Kante des Gehäuses, in welchem einer der Resonatoren montiert ist.

In einer weiteren Ausführungsform sind die Montageflächen der Resonatoren im Wesentlichen Quadratisch und die elektrischen Anschlüsse sind vorzugsweise entweder an den Resonatoren oder an dem oder den Substraten so ausgeführt, dass eine Anordnung möglich ist, bei der ein Resonator um 90° um die Achse senkrecht zur Montagefläche gedreht montiert werden kann. Somit ist es möglich, als die Achse, um die einer der Resonatoren gegenüber einem der anderen Resonatoren um 180 Grad gedreht wird, eine Diagonale durch die Montagefläche bzw. eine Parallele zu dieser zu wählen.

In einer weiteren Ausführungsform schlägt die Erfindung vor, dass die elektrischen Anschlüsse vorzugsweise entweder an den Resonatoren oder an dem oder den Substraten so ausgeführt sind, dass eine Anordnung möglich ist, bei der zumindest ein Resonator in mindestens 2 verschiedenen Ausrichtungen montiert werden kann, welche gegeneinander um die Achse senkrecht zur Montagefläche gedreht sind, wobei die elektrische Kopplung im Wesentlichen unabhängig von der Wahl der entsprechenden Ausrichtung ist. Dadurch ist es möglich, die Achse, um die der Resonator gegenüber einem anderen Resonator gedreht ist, um die Achse senkrecht zur Montagefläche zu drehen. Beispielsweise ist ein Resonator so konstruiert, dass er drehsymmetrisch ist, bei einer Drehung um 180° um die Achse senkrecht zu seiner Montagefläche. Wird dieser Resonator um besagte 180° um die Achse senkrecht zu seiner Montagefläche gedreht, ergibt dies effektiv eine Drehung der Achse, um die er gegenüber einem anderen Resonator um 180° gedreht ist, um 90° senkrecht zur Montagefläche. Dies ermöglicht es zum Beispiel, dass Resonatoren miteinander kombiniert werden können, bei denen die Richtungen der Vektoren der Beschleunigungsempfindlichkeit an einer Ebene gespiegelt ist die nicht senkrecht zu der Achse ist, um welche die Anschlüsse für die Montage des verdreht anzuordnenden Resonators gedreht sind, sondern um 90° um die Achse senkrecht zur Montagefläche gedreht.

Eine weitere Variante solch einer Ausführungsform stellt ein Substrat bereit, auf welchem die elektrischen Anschlüsse für mindestens einen Resonator wiederholt vorhanden sind, wobei die Anschlüsse jeweils im wesentlichen um eine Achse gedreht wiederholt sind, welche sich im Wesentlichen in der Mitte des Resonators senkrecht zur Montagefläche befindet. Vorzugsweise sind die wiederholten Anschlüsse jeweils um einen bestimmten Winkel gegeneinander verdreht angeordnet. Weiter bevorzugt entspricht dieser Winkel einem Teiler von 360°. Besonders bevorzugt sind Winkel von 22,5°, 30°, 45°, 60° und 90°. Beispielsweise sind die Anschlüsse vierfach vorhanden, wobei jeweils eine Drehung um 22,5° vorgenommen ist. Der Resonator kann also um 0°, 45°, 90° und 135° gedreht angeordnet werden. Ist der Resonator zusätzlich noch so ausgeführt, dass er um 180° um seine senkrechte Achse gedreht werden kann, ohne dass er sich dadurch im Wesentlichen elektrisch anders verhält (abgesehen von der Beschleunigungsempfindlichkeit), so kann er effektiv auch noch um 180°, 225°, 270° und 315° verdreht angeordnet werden.

Bei solchen Ausführungsformen kann die Achse, um welche die Resonatoren effektiv gegeneinander um 180° verdreht sind, ggf. in mehreren Schritten um die Achse, welche senkrecht zur Montagefläche ist, gedreht werden. Hierdurch wird auch die Ebene, die senkrecht zu der Achse ist, um welche die Resonatoren gegeneinander verdreht sind, um die Achse, welche senkrecht zur Montagefläche ist, gedreht. Dies ermöglicht es, Resonatoren auszuwählen, bei denen die Ebene, an der die Richtung des Vektors eines der beiden Resonatoren gegenüber der Richtung des anderen Resonators gespiegelt ist, nicht senkrecht zu einer Außenkante eines der Resonatoren ist, sondern gegenüber dieser um eine Achse, die senkrecht zu seiner Montagefläche ist, verdreht.

In weiteren Ausführungsformen ist mindestens ein Resonator, aber nicht alle Resonatoren, bereits bei der Montage in das Resonatorgehäuse um eine Achse um 180° gedreht. Be solchen Ausführungsformen kann bei der Anordnung der Resonatoren auf das oder die Substrate auf diese Verdrehung verzichtet werden. Liegt die Achse, um die der Resonator innerhalb seines Gehäuses um 180° verdreht ist, parallel zur Ebene seiner Montagefläche, kann sie durch die vorbeschriebene Drehung eines Resonators um die Achse, die senkrecht zu seiner Montagefläche ist, entsprechend gedreht werden. Hierdurch ergibt sich der Vorteil, dass bei der Montage der bereits verdreht ins Gehäuse eingebauten Resonatoren die Achse unabhängig von der Richtung des Vektors der Beschleunigungsempfindlichkeit festgelegt werden kann.

In weiteren Ausführungsformen ist die Achse, um welche mindestens einer der Resonatoren gegenüber mindestens einem anderen mechanisch verdreht ist, senkrecht zur Montagefläche eines der Resonatoren.

Erfindungsgemäß ist die besagte Ebene parallel oder senkrecht zur Montagefläche. Hierdurch ergibt sich vorteilhafterweise, dass die Montageflächen der Resonatoren vorzugsweise parallel zueinander sind. Der Vorteil, dass die Montageflächen der Resonatoren parallel zueinander sind, ergibt sich auch dann, wenn die Achse, um welche mindestens einer der Reonatoren gegenüber einem anderen um 180° verdreht ist, parallel oder senkrecht zur Montagefläche ist, weshalb dies in einer weiteren Ausführungsform vorgeschlagen wird. In weiteren Ausführungsformen wird vorgeschlagen, mindestens einen der Resonatoren so auszuführen, dass seine Montagefläche kreisförmig ist. Dies hat den Vorteil, dass auch bei Drehungen des Resonators um die Achse, welche senkrecht zu seiner Montagefläche ist, die kleiner als 90° sind, keine wesentlichen Verschiebungen der Masse (insbesondere der thermischen Masse) auftreten und dass der Platzbedarf für den Resonator auf dem Substrat minimiert wird.

Es wurde festgestellt, dass, wenn mehrere Resonatoren zu einem kombinierten Resonator (kombinierten frequenzbestimmenden Element) verbunden werden, der Einfluss der einzelnen Resonatoren auf die Frequenz des gewünschten Mode des kombinierten Resonators umgekehrt proportional zu ihrer Ziehfähigkeit ist. Ein Resonator, der mit einem zweiten Resonator zu einem kombinierten frequenzbestimmenden Element verbunden wird, welches die doppelte Ziehfähigkeit hat, hat selbst doppelt so viel Einfluss auf die Frequenz des kombinierten Mode. Damit beim Einwirken der gleichen Beschleunigung auf beide Resonatoren, die Frequenz des kombinierten Mode möglichst wenig beeinflusst wird, ist es vorteilhaft, wenn nicht die Beträge der Vektoren der Beschleunigungsempfindlichkeit im Wesentlichen gleich sind, sondern die beiden Produkte aus dem jeweiligen Betrag des Vektors der Beschleunigungsempfindlichkeit und dem jeweiligen relativen Anteil an der Frequenzbestimmung.

Der Betrag des Vektors der Beschleunigungsempfindlichkeit eines Resonators, dessen relativer Anteil an der Bestimmung der Frequenz doppelt so hoch ist, wie der eines zweiten, mit ihm zu kombinierenden Resonators, muss also im Wesentlichen halb so groß sein, wie dessen Betrag des Vektors der Beschleunigungsempfindlichkeit.

In weiteren Ausführungsformen wird deshalb vorgeschlagen, dass die Beträge der Vektoren der Beschleunigungsempfindlichkeit der Resonatoren im Wesentlichen in dem Verhältnis zueinander stehen, wie ihre Ziehfähigkeiten zueinander. Bei abweichenden Ziehfähigkeiten haben die Resonatoren also entsprechend abweichende Beträge der Beschleunigungsempfindlichkeit.

Viele Oszillatorschaltungen sind um den Resonator herum unsymmetrisch aufgebaut. Das heißt, dass die elektronische Schaltung auf beiden Seiten des Resonators nicht gleich, sondern unterschiedlich ist. Beispielsweise ist ein Anschluss des Resonators an den Ausgang eines Verstärkers angeschlossen und der andere Anschluss an den Eingang dieses Verstärkers. Somit sind die Anschlussimpedanzen an beiden Seiten des Resonators oft unterschiedlich. Unter anderem durch solche Unsymmetrien kommt es vor, dass das Verhältnis der Einflüsse der einzelnen Resonatoren des kombinierten frequenzbestimmenden Elements von dem Verhältniss der Kehrwerte ihrer Ziehfähigkeiten abweicht. Insbesondere kommt dies dadurch zustande, dass mehrere z. B. durch elektrische Serienschaltung (Reihenschaltung) kombinierte Resonatoren nicht nur eine simple Serienschaltung darstellen, sondern dass an ihrem Verbindungspunkt auch meistens eine parasitäre Kapazität zu anderen Knoten der elektrischen Schaltung auftritt. Diese parasitäre Kapazität kann zum Beispiel je nach Ausführung der Oszillatorschaltung den Einfluss eines der Resonatoren auf die Frequenz des kombinierten Mode stärker verringern als den des andern Resonators bzw. eines der anderen Resonatoren.
Um diesem Umstand Rechnung zu tragen, wird in weiteren Ausführungsformen vorgeschlagen, dass die Beträge der Vektoren der Beschleunigungsempfindlichkeit der Resonatoren im Wesentlichen in dem Verhältnis zueinander stehen, wie der Kehrwert ihrer Ziehfähigkeit in der Oszillatorschaltung zueinander.
Eine weitere Möglichkeit, besteht darin, die parasitären Kapazitäten an den Verbindungspunkten der einzelnen Resonatoren durch Parallelschaltung von Induktivitäten zu kompensieren. Vorzugsweise wird von mindestens einem Knotenpunkt, an dem zwei Resonatoren miteinander verbunden sind, eine Induktivität zu dem Knotenpunkt geschaltet, zu dem sich auch die parasitäre Kapazität des Verbindungspunktes ausbildet. Üblicherweise ist dies die Schaltungsmasse. Der Wert der Induktivität wird im Wesentlichen so gewählt, dass sich zusammen mit der parasitären Kapazität ein Schwingkreis mit einer Parallelresonanz bei oder in der Nähe der Frequenz des gewünschten Mode des kombinierten frequenzbestimmenden Elements ergibt, was in einer weiteren Ausführungsform vorgeschlagen wird.

Die Kopplung der Resonatoren erfolgt vorzugsweise direkt, also ohne zwischengeschaltete andere Schaltungselemente, um eine möglichst dämpfungsarme Kombination der gewünschten Moden zu erreichen.
Die Kopplung kann aber auch über reaktive Komponenten erfolgen, da diese nur eine sehr geringe Dämpfung aufweisen. Beispielsweise kann die Kopplung erfolgen über zwischen den frequenzbestimmenden Elementen angeordnete Induktivitäten, Kapazitäten, Elemente mit kapazitätsveränderlichen Sperrschichten, wie z.B. Kapazitätsdioden, als kapazitätsveränderliche Elemente geschaltete Feldeffekttransistoren, etc.

Die gekoppelten Elemente bilden ein kombiniertes frequenzbestimmendes Element, dessen gewünschter Mode, bzw. dessen gewünschte Moden zwischen den in unmittelbarer Nähe liegenden Moden der verwendeten frequenzbestimmenden Elemente liegen. Die Lage des kombinierten Modes (bzw. der kombinierten Resonanzstelle) zwischen den in unmittelbarer Nähe liegenden Moden bestimmt sich nach dem Verhältnis deren jeweiliger Ziehfähigkeit (Veränderbarkeit der resultierenden Resonanzfrequenz durch Beschaltung mit vorzugsweise variablen Reaktanzen. Der in der Frequenz höher liegende Mode wirkt für den anderen Mode effektiv wie eine Ziehkapazität, und der andere Mode wirkt für ihn wie eine Ziehinduktivität.

Bei vielen frequenzbestimmenden Elementen, wie z.B. Schwingquarzen, ergibt sich eine Signalübertragung nicht nur bei oder in unmittelbarer Nähe der Frequenzen der Schwingungsmoden, sondern auch eine normalerweise unerwünschte Signalübertragung durch bestimmte Physikalische Effekte, wie z.B. die statische (parasitäre) Kapazität von Schwingquarzen.
Üblicherweise werden frequenzbestimmende Elemente in elektronischen Schaltungen mit ihrem elektrischen Ersatzschaltbild dargestellt, welches meist aus einer Induktivität (L1), welche die kinetische Masse des mechanischen Äquivalenzmodells darstellt, einer Kapazität (C1), welche die Elastizität des mechanischen Äquivalenzmodells darstellt, und eines Widerstandes (R1), welcher die Verluste, wie z.B. die inneren Reibungsverluste, des mechanischen Äquivalenzmodells darstellt. Zusätzlich muss die beschriebene unerwünschte Signalübertragung implementiert werden, was üblicherweise in Form einer zusätzlichen parasitären Kapazität (C0) realisiert wird.
Meist stellt das elektrische Ersatzschaltbild eine Serienschaltung der drei Hauptelemente (L1, C1 und R1) dar, zu der die parasitäre Kapazität (C0) parallel geschaltet ist.

Werden nun mehrere frequenzbestimmende Elemente gekoppelt, die gewünschte und unerwünschte Moden aufweisen, bei denen aber nur die gewünschten Moden beider frequenzbestimmender Elemente in unmittelbarer Nähe liegen, kann es vorkommen, dass durch die unerwünschte Signalübertragung, welche durch das parasitäre C0 dargestellt wird, auch unerwünschte Moden eines der frequenzbestimmenden Elemente dominant werden (also geringere Dämpfung aufweisen) gegenüber dem oder den gewünschten kombinierten Moden.

Durch die geringe Größe des parasitären C0 ergibt sich zwar eine Frequenzverschiebung ähnlich des über eine Ziehkapazität verursachten Zieheffektes, die Dämpfung des unerwünschten Modes wird aber unter Umständen nur gering erhöht (Transformation von R1 in R1', siehe Das Quarzkochbuch, Bernd Neubig). Da sich durch Kopplung der erwünschten Moden zweier frequenzbestimmender Elemente deren Dämpfungen addieren, kann es vorkommen, dass durch den Einfluss von C0 unerwünschte Moden eine geringere Gesamtdämpfung aufweisen, als der oder die gewünschten Moden.

Selbst wenn die Gesamtdämpfung größer ist, als die des gewünschten kombinierten Modes, kann es vorkommen, dass im Ausgangssignal des Oszillators Anteile dieser unerwünschten Frequenzen vorhanden sind.

Ebenso kann es vorkommen, dass die Moden einzelner frequenzbestimmender Elemente, welche gemeinsam den gewünschten Mode des kombinierten frequenzbestimmenden Elements bilden, durch die Kopplung des C0 anderer frequenzbestimmenden Elemente bei dem kombinierten frequenzbestimmenden Element als unerwünschte Moden auftreten.
Solche Moden, die entstehen, wenn Moden einzelner Elemente, welche Teile des gewünschten Modes des kombinierten frequenzbestimmenden Elements sind, über parasitäre Kapazitäten anderer Elemente gekoppelt werden, werden im Folgenden auch als unerwünschte Moden bezeichnet.

Werden z.B. zwei frequenzbestimmende Elemente gekoppelt, die jeweils einen gewünschten Mode mit einer Serienresonanz von 10MHz haben, die allerdings auch eine parasitäre Parallelkapazität C0 haben, und deren gezogene Serienresonanz bei einer Serienschaltung der einzelnen Elemente mit einer Ziehkapazität in der Höhe des C0 des anderen Elements beispielsweise bei 10,0001 MHz liegt, ergibt sich ein kombiniertes frequenzbestimmendes Element mit einem Mode bei 10MHz und zwei Moden bei ca. 10,0001MHz. Abhängig von den sonstigen Ersatzdaten der Elemente (R1, L1, C1) haben diese Moden bestimmte effektive Serienresonanzwiderstände, wobei der Serienresonanzwiederstand des gewünschten Modes bei 10MHz die Summe der Serienresonanzwiderstände der gewünschten Moden beider Elemente ist, der Serienresonanzwiderstand der ungewünschten Moden der transformierte Serienresonanzwiderstand bei Verwendung einer Ziehkapazität entsprechend dem C0 des jeweils anderen Elements.
Es kann unter Umständen vorkommen, dass die Serienresonanzwiderstände solcher unerwünschter Moden niedriger sind, als der Serienresonanzwiderstand des gewünschten Modes, oder zumindest so niedrig, dass entsprechende unerwünschte Frequenzen im Ausgangssignal vorhanden sind. In solchen Fällen kann es wünschenswert sein, solche unerwünschte Moden zu unterdrücken, wie es dies auch bei anderen unerwünschten Moden sein kann.

Da ein Parallelschwingkreis in der Nähe seiner Resonanzfrequenz nur eine sehr geringe Signalübertragung aufweist, schlägt die Erfindung in einer Variante vor, dass mindestens einem frequenzbestimmenden Element mindestens eine Induktivität parallelgeschaltet wird, welche zusammen mit dem C0 dieses Elementes in der Nähe eines oder mehrerer Moden des anderen oder eines der anderen frequenzbestimmenden Elemente in Parallelresonanz ist, um die Dämpfung des oder der unerwünschten Moden, bzw. die Dämpfung der durch Kopplung eigentlich erwünschter Moden über das C0 anderer Elemente entstehender Moden zu erhöhen.

Für den Fall, dass beide frequenzbestimmenden Elemente unerwünschte Moden aufweisen, die in Zusammenwirkung mit dem parasitären C0 des anderen oder eines der andern frequenzbestimmenden Elemente entsprechend dämpfungsarme Resonanzen darstellen können, schlägt die Erfindung in einer weiteren Variante vor, dass mehreren oder allen frequenzbestimmenden Elementen entsprechende Induktivitäten parallel geschaltet werden.

Um eine gewisse Reserve gegenüber Fertigungstoleranzen bei den Resonatoren zu erreichen, kann es auch vorteilhaft sein, generell mehreren oder allen frequenzbestimmenden Elementen entsprechende Induktivitäten parallel zu schalten.

Da Induktivitäten in elektronischen Schaltungen ungern eingesetzt werden, u.a. wegen ihres ungünstigen Temperaturverhaltens, des relativ hohen Preises und des nicht zu vernachlässigenden Platzbedarfes, wurde nach einer alternativen Methode zur Unterdrückung der parasitären Kopplung gesucht.

Es wurde festgestellt, dass sich mittels eines Widerstandes, welcher zumindest einem der frequenzbestimmenden Elemente, oder einer Serienschaltung aus zumindest einem der frequenzbestimmenden Elemente und mindestens einer Reaktanz, wie z.B. einer Koppel und/oder Ziehkapazität, parallel geschaltet wird, die Dämpfung von unerwünschten Schwingungsmoden erhöhen lässt, und zwar in einem stärkeren Maße, als dadurch der oder die gewünschten Schwingungsmoden gedämpft werden.

Die Erfindung schlägt deshalb in einer weiteren Variante vor, zumindest einem der frequenzbestimmenden Elemente einen Widerstand parallel zu schalten, und zwar entweder direkt, oder ebenfalls über ein oder mehrere in Serie zu diesem geschalteten reaktiven Elemente (Induktivitäten und/oder Kondensatoren), so dass er diesem effektiv parallel geschaltet ist.

Da Widerstände üblicherweise kostengünstig, mit kleinen Abmessungen und mit gutem Temperaturverhalten hergestellt werden können, bedeutet diese Variante eine deutliche Verbesserung der Erfindung.

Weiter wurde festgestellt, dass das Verhältnis der Dämpfung unerwünschter Moden zur Dämpfung erwünschter Moden besonders vorteilhaft ist, wenn die Resonatoren möglichst nahe bei der Serienresonanz des gewünschten Mode betrieben werden. Um die erwünschten Moden möglichst wenig zu bedämpfen schlägt die Erfindung in einer weiteren Variante vor, dass die Schwingquarze oder andere Resonatoren möglichst nahe bei der Serienresonanz des gewünschten Mode betrieben werden, vorzugsweise mit einem Abstand von der Serienresonanzfrequenz von weniger als 30% des Abstandes der Parallelresonanz von der Serienresonanzfrequenz, mehr bevorzugt mit einem Abstand von weniger als 10%, noch mehr bevorzugt weniger als 5% und besonders bevorzugt mit einem Abstand von weniger als 2%.

Eine Anwendung der Erfindung besteht beispielsweise aus einem Quarzoszillator, der mit einem Schwingquarz ausgestattet ist, der mit einem SC Schnitt realisiert ist. Schwingquarze, die auf einem SC Schnitt beruhen weisen mindestens 2 Moden auf, welche sich in der Frequenz um ca. 9% unterscheiden, und von denen der tiefer liegende Mode (C-Mode) gegenüber dem höherliegenden Mode (B-Mode) bevorzugt wird, da er ein vorteilhaftes Temperaturverhalten aufweist.
Durch die relative Nähe der beiden Moden ist einiges an Schaltungsaufwand erforderlich, um nur den gewünschten Mode zur Schwingung anzuregen, wie bereits in der Beschreibung des Standes der Technik erläutert wurde. Hierbei kommen teilweise mehrere Induktivitäten zum Einsatz, deren Nachteile bereits erläutert wurden. Ebenfalls weisen Schwingquarze nicht nur andere Arten von Schwingungsmoden auf (C-Mode, B-Mode, etc.), sondern auch Moden bei unterschiedlichen Harmonischen bzw. Obertönen. Da aus bestimmten Gründen (z.B. besseres Alterungsverhalten) gerne höhere Obertöne verwendet werden, niedrigere Obertöne aber meist geringere Dämpfungen aufweisen, muss oft eine weitere Selektion eingebaut werden, was die Komplexität der elektronischen Schaltung weiter erhöht, z.B. durch die Erfordernis weitere Induktivitäten zu verwenden.
Die beispielhafte Realisierung eines solchen Oszillators unter Verwendung der erfindungsgemäßen Methode ist im folgenden Beispiel dargestellt. Durch Kopplung des Schwingquarzes im SC Schnitt im dritten Oberton, welcher einen gewünschten Mode bei 10MHz (Serienresonanzwiderstand 40 Ohm) und zwei dämpfungsärmere unerwünschte Moden bei 3,333MHz (Serienresonanzwiderstand 20 Ohm) und 10,9 MHz (Serienresonanzwiderstand 35 Ohm) aufweist, mit einem weiteren Schwingquarz im AT Schnitt im Grundton, welcher einen gewünschten Mode bei 10MHz (Serienresonanzwiderstand 10 Ohm), aber keine unerwünschten Moden in der Nähe von 3,333MHz oder 10,9MHz aufweist, entsteht ein kombiniertes frequenzbestimmendes Element, das kombinierte Moden aufweist bei ca. 3,333MHz, 10MHz und ca. 10,9MHz, wobei die beiden unerwünschten Moden nun stärker gedämpft sind. Der Serienresonanzwiderstand bei 10MHz liegt bei 50 Ohm. Außerdem weist das kombinierte Element einen weiteren Mode auf, der einige ppm oberhalb von 10MHz liegt (Serienresonanzwiderstand 48 Ohm).
Durch Schaltung eines Widerstandes mit 1000 Ohm parallel zu dem Schwingquarz im AT Schnitt erhöht sich die Dämpfung der unerwünschten Moden deutlich, bei einer zu vernachlässigenden Erhöhung der Dämpfung des gewünschten Mode.
Hierdurch kann in solchen Fällen auf jegliche Induktivitäten in der elektronischen Schaltung verzichtet werden.
Im Falle unerwünschter Nebenresonanzen, wie sie z.B. bei Schwingquarzen abhängig von der Elektrodengroße auftreten, kann die Bedämpfungsmaßnahme äquivalent eingesetzt werden.

Auch wenn die parasitäre(n) Kapazität(en) beispielsweise mithilfe von Induktivitäten im Bereich des oder der gewünschten Moden zumindest teilweise kompensiert werden, z.B. um eine linearere Frequenzmodulation durch weitere in der Oszillatorschaltung verwendete veränderliche Reaktanzen zu ermöglichen, kann es dazu kommen, dass ein oder mehrere unerwünschte Moden eine geringere Dämpfung als der gewünschte Mode haben, bzw. dass sich zusammen mit der Oszillatorschaltung eine Schwingung auf einem unerwünschten Moder ergibt.
In einer weiteren Variante der Erfindung wird deshalb vorgeschlagen, zusätzlich zu der oder den vorbeschriebenen Induktivitäten zumindest einem der frequenzbestimmenden Elemente einen Widerstand parallel zu schalten, und zwar entweder direkt, oder ebenfalls über ein oder mehrere in Serie zu diesem geschalteten reaktiven Elemente (z.B. Induktivitäten und/oder Kondensatoren).

Im Laufe der Erfindung wurde festgestellt, dass es vorteilhaft ist, wenn der oder die Widerstände von ihrem Widerstandswert her vorzugsweise so niedrig dimensioniert werden, dass eine wesentliche Dämpfung der unerwünschten Moden erreicht wird. Die Dämpfung des gewünschten Modes sollte vorzugsweise so gering wie möglich sein. Anders ausgedrückt, soll die Güte des oder der unerwünschten Moden möglichst stark, die Güte des oder der erwünschten Moden möglichst wenig verringert werden. Es

Besonders bevorzugt liegt der Widerstandswert eines parallel geschalteten Widerstandes maximal um den Faktor 100 über dem Serienresonanzwiderstand des gewünschten Modes des kombinierten frequenzbestimmenden Elements, weil eine damit eintretende Verschlechterung der Güte von ca. 1% fast immer tolerabel ist und bei sehr hohen Faktoren, beispielsweise 1000 und darüber, meist keine wesentliche Dämpfung unerwünschter Moden erreicht wird.
Besonders bevorzugt liegt der Widerstandswert eines parallel geschalteten Widerstandes maximal um den Faktor 30 über dem Serienresonanzwiderstand des gewünschten Modes, weil eine damit eintretende Verschlechterung der Güte von ca. 3% üblicherweise tolerabel ist und eine bessere Dämpfung unerwünschter Moden erreicht wird.
Um die Güte des gewünschten Modes nicht zu sehr zu verschlechtern, liegt der Widerstandswert eines parallel geschalteten Widerstandes vorzugsweise mindestens um den Faktor 5 über dem Serienresonanzwiderstand des gewünschten Modes. Die damit einhergehende Verschlechterung der Güte um ca. 20% liegt im Bereich gängiger Fertigungstoleranzen von Resonatoren, so dass bei Faktoren unter 5 die Verschlechterung der Güte für bestimmte Anwendungen inakzeptabel sein kann.
Der Faktor kann aber auch niedriger als 5 gewählt werden, z.B. im Bereich 2 bis 5, beispielsweise wenn die Verschlechterung der Güte tolerabel ist, oder bei höheren Faktoren eine ausreichende Dämpfung der unerwünschten Moden nicht sicher erreicht werden kann.
Besonders bevorzugt liegt der Widerstandswert eines parallel geschalteten Widerstandes vorzugsweise mindestens um den Faktor 10 über dem Serienresonanzwiderstand des gewünschten Modes, damit eine möglichst hohe Güte des gewünschten Modes erhalten bleiben kann.

Werte vom 15- bis 25-fachen des Serienresonanzwiderstandes des gewünschten Modes haben sich als besonders vorteilhaft herausgestellt.

Vorgenannter Widerstand kann sowohl ein reiner ohmscher Widerstand sein, beispielsweise ein Bauelement mit einem Strompfad aus einem Material, das einen höheren spezifischen Widerstand als Kupfer hat, insbesondere aus einer Nickel-Chrom-Legierung oder aus einer auf ein Keramiksubstrat aufgebrannten metalloxidhaltigen Paste (Dickschichtwiderstand), als auch ein variabler Wiederstand, wie z.b. ein als Steuerbarer Widerstand beschalteter Feldeffekttransistor.
Durch die Verwendung eines variablen Widerstandes ist es möglich, die Dämpfung einzustellen, ggf. abhängig von spezifischen Eigenschaften des Resonators, der Umgebungstemperatur oder anderen Parametern, welche die frequenzbestimmenden Elemente der Schaltung beeinflussen können. Dies stellt eine weitere Variante der Erfindung dar.

Die beschriebenen Möglichkeiten mehrere Resonatoren zu einem kombinierten frequenbestimmenden Element zu kombinieren können auch unabhängig von einer Verringerung der Beschleunigungsempfindlichkeit eingesetzt werden, beispielsweise zur Selektion bestimmter erwünschter Moden oder zur Unterdrückung unerwünschter Moden ansonsten einzeln eingesetzter Resonatoren oder bei Resonatoren, welche aus anderen Gründen kombiniert werden.

Die in verschiedenen Ausführungsformen vorgeschlagenen Merkmale sind, soweit sie sich nicht offensichtlich gegenseitig ausschließen, auch in Kombinationen anwendbar und als Ausführungsformen der Erfindung anzusehen, die nicht explizit aufgeführt sind. Insbesondere sind die beschriebenen Maßnahmen zur vorteilhafteren Selektion gewünschter Moden, bzw. zur Unterdrückung unerwünschter Moden unabhängig von den mechanischen Anordnungen der Resonatoren anwendbar.

## Patentansprüche

1. Ein Oszillator umfassend
eine elektronische Schaltung gestützt von einem Substrat oder mehreren miteinander gekoppelten Substraten und ausgestaltet periodische Schwingungen zu initiieren und
zu erhalten,
mindestens zwei von mindestens einem der Substrate gestützte Resonatoren, von welchen jeder eine im Wesentlichen planare Montagefläche und eine
Beschleunigungsempfindlichkeit mit einem Vektor aufweist, welcher einen Betrag und
eine Richtung umfasst, wobei die
mindestens zwei Resonatoren operativ mit der elektronischen Schaltung gekoppelt sind und als ein verbundener Resonator fungieren, um die Frequenz der Schwingung zu beeinflussen, und
wobei die Ebenen der Montageflächen der Resonatoren im Wesentlichen parallel zueinander angeordnet sind,
wobei die auf seine Montagefläche bezogene Richtung des Vektors der Beschleunigungsempfindlichkeit mindestens eines ersten Resonators der mindestens zwei Resonatoren im Wesentlichen der an einer Spiegelebene gespiegelten Richtung des Vektors der Beschleunigungsempfindlichkeit mindestens eines zweiten Resonators der mindestens zwei Resonatoren, bezogen auf dessen Montagefläche, entspricht,
und
besagter erster Resonator gegenüber besagtem zweitem Resonator mechanisch verdreht angeordnet ist, und zwar um 180° gedreht um die Achse, die
senkrecht zu besagter Spiegelebene ist,
**dadurch gekennzeichnet, dass**
besagte Spiegelebene senkrecht oder parallel zur Ebene der Montageflächen der Resonatoren ist.

2. Oszillator nach Anspruch 1, **gekennzeichnet dadurch, dass**
besagte Spiegelebene parallel zu einer Kante mindestens eines der Resonatoren ist.

3. Oszillator nach Anspruch 1, **gekennzeichnet dadurch, dass**
besagte Spiegelebene um 45° um die Achse, die senkrecht zur Montagefläche ist,
gedreht gegenüber einer Kante mindestens eines der Resonatoren ist.

4. Oszillator nach einem der vorhergehenden Ansprüche, **gekennzeichnet dadurch,**
**dass**
die Vektoren nicht im Wesentlichen senkrecht zu der Achse sind, um welche mindestens einer der Resonatoren gegenüber mindestens einem anderen der Resonatoren verdreht ist.

5. Oszillator nach einem der Ansprüche 1 bis 4, **gekennzeichnet dadurch, dass** die Beträge der Vektoren besagter Resonatoren sich im Wesentlichen zueinander verhalten wie die Beträge ihrer Ziehfähigkeiten.

6. Oszillator nach einem der vorhergehenden Ansprüche, **gekennzeichnet dadurch,**
**dass**
der Oszillator mindestens einen Widerstand umfasst, der einem der Resonatoren effektiv parallel geschaltet ist, und dass
dessen Widerstandswert geringer ist, als das Einhundertfache des
Serienresonanzwiderstandes des kombinierten Resonators bei der gewünschten Resonanzfrequenz, vorzugsweise geringer als das Dreißigfache, besonders bevorzugt liegt der Widerstandswert im Bereich zwischen dem Fünffachen und dem
Fünfundzwanzigfachen des Serienresonanzwiderstandes des kombinierten Resonators bei der gewünschten Resonanzfrequenz.

7. Oszillator nach Anspruch 6, **gekennzeichnet dadurch, dass**
besagter Widerstand, der einem der Resonatoren effektiv parallel geschaltet ist, einen Widerstandswert aufweist, der mindestens um den Faktor 5 über dem Serienresonanzwiderstand des gewünschten Modes liegt.

8. Ein Oszillator nach einem der vorhergehenden Ansprüche, **gekennzeichnet dadurch,**
**dass** mindestens 2 Resonatoren zu einem gemeinsamen Resonator
zusammengeschaltet sind, indem sie effektiv in Serie geschaltet sind, und
**dass** die effektive Serienschaltung durch Verbinden je einer Elektrode des
ersten Resonators mit einer Elektrode des zweiten Resonators realisiert ist, und zwar durch Verbinden der genannten Elektroden über ein oder mehrere weitere elektronische Bauelemente, vorzugsweise Kapazitäten und/oder Induktivitäten, wobei der Realteil des Widerstandes der Verbindung vorzugsweise kleiner ist, als der
Serienresonanzwiderstand eines der beiden Resonatoren, mehr bevorzugt kleiner als ein Drittel davon, besonders bevorzugt kleiner als ein Zehntel.

9. Ein Oszillator nach einem der vorhergehenden Ansprüche, **gekennzeichnet dadurch,**
**dass** von mindestens einem Verbindungspunkt zwischen zwei Resonatoren eine Induktivität zu einem anderen Verbindungspunkt der elektrischen Schaltung, vorzugsweise nach Masse, geschaltet ist, um die parasitäre Kapazität, die zwischen dem vorgenannten Verbindungspunkt und dem anderen Knotenpunkt der Schaltung auftritt, zu kompensieren, vorzugsweise im Wesentlichen mit solch einem Induktivitäts-Wert, dass sich zusammen mit der von diesem Verbindungspunkt effektiv zu anderen Knotenpunkten der Schaltung bzw. nach Masse wirksamen parasitären Kapazität ein Schwingkreis mit einer Parallelresonanz bei oder nahe der Frequenz des gewünschten Mode des kombinierten frequenzbestimmenden Elements ergibt.

## Claims

1. An oscillator comprising
an electronic circuit, supported by a substrate or a plurality of substrates coupled to one another, and configured to initiate and obtain periodic oscillations,
at least two resonators supported by at least one of the substrates, each of which has a substantial planar mounting surface and an acceleration sensitivity with a vector, which has a magnitude and a direction, wherein the at least two resonators are operatively coupled to the electronic circuit and function as a combined resonator, in order to control the frequency of the oscillation, and wherein the planes of the mounting surfaces of the resonators are arranged substantially parallel to one another,
wherein the direction of the vector of the acceleration sensitivity of at least a first resonator of the at least two resonators, relative to its mounting surface, substantially corresponds to the direction of the vector of the acceleration sensitivity of at least a second resonator of the at least two resonators, relative to that one's mounting surface, when the direction of the vector of the acceleration sensitivity of said second resonator is mirrored at a mirror plane
and
said first resonator is arranged in a mechanically rotated manner relative to said second resonator, rotated by 180° around the axis which is perpendicular to said mirror plane,
**characterized in that**
said mirror plane is perpendicular or parallel to the plane of the mounting surfaces of the resonators.

2. Oscillator according to claim 1, **characterized in that**
said mirror plane is parallel to an edge of at least one of the resonators.

3. Oscillator according to claim 1, **characterized in that**
said mirror plane is rotated by 45° with respect to an edge of at least one of the resonators around the axis, which is perpendicular to the mounting surface.

4. Oscillator according to one of the preceding claims, **characterized in that**
the vectors are not substantially perpendicular to the axis around which at least one of the resonators is rotated with respect to at least one of the other resonators.

5. Oscillator according to one of claims 1 to 4, **characterized in that**
the magnitudes of the vectors of said resonators are in a ratio substantially the same as the magnitudes of their pullabilities.

6. Oscillator according to one of the preceding claims, **characterized in that**
the oscillator comprises at least one resistor which is effectively connected in parallel to one of the resonators, and **in that**
its resistance value is less than one hundred times the series resonance resistance of the combined resonator at the desired resonance frequency, preferably less than thirty times, particularly preferably the resistance value is in the range between five times and twenty-five times of the series resonance resistance of the combined resonator at the desired resonance frequency.

7. An oscillator according to claim 6, **characterized in that** said resistor, which is connected effectively in parallel to one of said resonators, has a resistance value, which is at least by a factor of 5 above the series resonance resistance of the desired mode.

8. An oscillator according to one of the preceding claims, **characterized in that** at least 2 resonators are connected to form a common resonator, by being connected effectively in series, and that the effective series circuit is realized by connecting one electrode of the first resonator to an electrode of the second resonator, in fact by connecting said electrodes via one or more further electronic components, preferably capacitors and/or inductances, wherein the real part of the resistance of the connection is preferably smaller than the series resonance resistance of one of the two resonators, more preferably smaller than one third thereof, particularly preferably smaller than one tenth.

9. An oscillator according to one of the preceding claims, **characterized in that** an inductance is connected from at least one connecting point between two resonators to another connection point of the electronic circuit, preferably to the circuit ground, in order to compensate for the parasitic capacitance that arises between the aforementioned connection point and the other connection point of the circuit, preferably substantially having such an inductance value, so that, together with the effective parasitic capacitance from this connecting point to other connection points of the circuit or, if applicable, to the circuit ground, a resonant circuit having a parallel resonance at or near the frequency of the desired mode of the combined frequency determining elements arises.

## Revendications

1. Un oscillateur comprenant
un circuit électronique supporté par un substrat ou plusieurs
substrats couplés et configuré pour initier des oscillations périodiques et
pour les recevoir,
au moins deux résonateurs supportés par au moins un des substrats,
chaque de ces résonateurs a une surface de montage essentiellement plane et une sensibilité d'accélération avec un vecteur qui comprend une norme et
une direction, où
au moins les deux résonateurs sont couplés avec le circuit électronique
et agissent comme un résonateur connecté pour contrôler la fréquence de l'oscillation,
et
les plans des surfaces de montage des résonateurs sont essentiellement disposés parallèlement les uns aux autres,
et la direction, par rapport à la surface de montage, du vecteur de sensibilité d'accélération d'au moins un premier résonateur d'au moins deux résonateurs
correspond essentiellement à la direction réfléchie sur un plan de symétrie, du vecteur de sensibilité d'accélération d'au moins un deuxième résonateur
des au moins deux résonateurs, par rapport à leur surface de montage,
et
le premier résonateur est, par rapport au deuxième résonateur
placé mécaniquement, cela veut dire qu'il est tourné de 180° autour de l'axe qui est perpendiculaire au plan de symétrie
qui se **caractérise par le fait que**
le plan de symétrie est perpendiculaire ou parallèle au plan des surfaces de montage des résonateurs.

2. Oscillateur selon la revendication 1, **caractérisé par**
que le plan de symétrie soit parallèle à un bord d'au moins un des résonateurs.

3. Oscillateur selon la revendication 1, **caractérisé par**
que le plan de symétrie soit à 45° autour de l'axe perpendiculaire à la surface de montage, est tourné au bord d'au moins un des résonateurs.

4. Oscillateur selon l'une des revendications précédentes, **caractérisé par**
que les vecteurs ne sont pas essentiellement perpendiculaires à l'axe autour duquel au moins un des résonateurs est tordu par rapport à au moins un autre résonateur.

5. Oscillateur selon l'une des revendications 1 à 4, **caractérisé par le fait que**
les normes des vecteurs des résonateurs se comportent essentiellement les unes aux autres comme les normes de leurs élongations.

6. Oscillateur selon l'une des revendications précédentes, **caractérisé par**
que l'oscillateur contient au moins une résistance qui soit
effectivement connecté en parallèle à l'un des résonateurs, et que
dont la valeur de résistance est inférieure à cent fois la valeur
de la résistance de la résonance de série du résonateur combiné à la fréquence résonante souhaité, de préférence moins de trente fois, particulièrement préférée la valeur de résistance est comprise entre cinq fois et
vingt-cinq fois la résistance de la résonance en série du résonateur combiné à la fréquence de résonance souhaité.

7. Oscillateur selon la revendication 6, **caractérisé par le fait que**
la résistance, qui est effectivement connecté en parallèle à l'un des résonateurs, a une valeur de résistance
qui est au moins un facteur de 5 au-dessus de la résistance de la résonance en série du mode souhaité.

8. Un oscillateur selon l'une des revendications précédentes, **caractérisé par**
qu'au moins 2 résonateurs soient interconnectés dans un résonateur,
en étant effectivement connectés en série, et
que la connexion en série soie réalisé en connectant une électrode du
premier résonateur avec une électrode du deuxième résonateur, par
connexion des électrodes via une ou plusieurs autres
composants électroniques, de préférence des capacités et/ou des inductances, où la partie réelle de la
résistance de la connexion est de préférence inférieure à la
résistance de la résonance en série de l'un des deux résonateurs, de préférence moins qu' un tiers, surtout de préférence moins d'un dixième.

9. Un oscillateur selon l'une des revendications précédentes, **caractérisé par** qu'à partir d'au moins un point de connexion entre deux résonateurs une inductance étant connectée à un autre point de connexion du circuit électrique, de préférence par masse,
pour compenser la capacité parasitaire qui se produit entre le point de connexion mentionné et l' autre nœud du circuit, de préférence avec une
valeur d'inductance telle que, ensemble avec ce point de connexion et
d'autres nœuds du circuit ou par la capacité parasitaire effective de masse,
se produit un circuit oscillant avec une résonance parallèle à ou près de la fréquence du mode désiré de
l' élément combiné déterminant la fréquence.
